# FASCICULE DE BREVET EUROPEEN

(11) **EP 0 540 092 B1**
(45) Date de publication et mention de la délivrance du brevet: **10.01.1996**
(21) Numéro de dépôt: 92203246.1
(22) Date de dépôt: 22.10.1992
(51) Int. Cl.: H01L 31/0232

(54) **Détecteur d'images à lumière parasite réduite et application à un senseur de terre**
Bilddetektor mit vermindertem Störlicht und Anwendung auf einen Endsensor
Image detector with reduced parasitic light and application to an earth sensor

(30) Priorité: 30.10.1991 FR 9113404
(43) Date de publication de la demande: 05.05.1993
(73) Titulaire: SOCIETE ANONYME D'ETUDES ET REALISATIONS NUCLEAIRES S.O.D.E.R.N., F-94450 Limeil-Brevannes (FR); Philips Electronics N.V., NL-5621 BA Eindhoven (NL)
(72) Inventeur: Pezant, Christian Société Civile S.P.I.D., F-75008 Paris (FR)
(74) Mandataire: Pyronnet, Jacques

(56) Documents cités:
- EP-A- 0 253 664
- FR-A- 2 533 883
- US-A- 4 401 887
- PATENT ABSTRACTS OF JAPAN vol. 8, no. 247 (E-278)(1684) 13 Novembre 1984 & JP-A-59 123 259
- PATENT ABSTRACTS OF JAPAN vol. 10, no. 356 (E-459)(2412) 29 Novembre 1986 & JP-A-61 154 184

## Description

L'invention concerne un détecteur d'images comportant une surface sensible à un rayonnement photonique, protégée du milieu extérieur par une fenêtre transparente solidaire d'un boîtier et placée, avec un dioptre interne et un dioptre externe, devant ladite surface sensible, cette dernière présentant un état de surface propre à engendrer des réflexions de rayonnement selon des angles pouvant atteindre plusieurs dizaines de degrés par rapport à la direction de réflexion spéculaire sur ladite surface.

L'invention s'applique notamment aux senseurs de terre et plus particulièrement aux senseurs de terre, à matrice d'éléments photosensibles à transfert de charges (matrice CCD), pour satellites géostationnaires.

Les détecteurs d'images peuvent être classés en deux familles : celles des tubes à vide dont la surface sensible exposée au rayonnement photonique est une photocathode et celle des composants semi-conducteurs organisés sous forme de barrettes ou de matrice d'éléments d'image (ou pixels). Dans la plupart des cas, la surface photosensible de ces détecteurs nécessite une protection contre la pollution ou les dégradations engendrées par le milieu extérieur environnant le détecteur, qu'il s'agisse de poussières dans l'atmosphère terrestre ou des constituants même de cette atmosphère. Cette protection consiste en une fenêtre (ou hublot), agencée de façon étanche devant la surface sensible, transparente au rayonnement photonique auquel est sensible le détecteur considéré. La fenêtre est constituée par un verre de qualité optique présentant un dioptre interne et un dioptre externe. Le contraste de l'image à analyser peut être dégradé, en présence d'une source de fort éclairement dans le champ de vision, par les réflexions multiples engendrées, à partir de la surface sensible elle-même, par des réflexions secondaires parasites sur les 2 dioptres de la fenêtre de protection. Dans le cas de l'observation de points ou de taches lumineuses très intenses sur un fond faiblement éclairé, ces réflexions parasites provoquent, sur la surface photosensible, des halos dont les niveaux peuvent être beaucoup plus importants que la scène observée, sur terre, ou, dans l'espace, que toute autre source lumineuse de moindre importance que l'on souhaite observer et qui constitue donc le signal utile, dès lors noyé dans le bruit. Un cas typique de ce problème technique se présente lorsque le détecteur d'image est un senseur de limbe terrestre, embarqué sur un satellite géostationnaire, constitué par une matrice CCD dans un domaine de rayonnement englobant tout le rayonnement visible et le proche infrarouge. D'autre part, la terre doit être vue en permanence par le détecteur, pour un fonctionnement nominal de ce dernier, et l'orbite du satellite est telle que pendant plusieurs mois dans l'année, aux approches de chaque équinoxe, le soleil est dans le champ du détecteur pendant plusieurs heures, autour de minuit local terrestre, à chaque révolution de 24 h. Dans cette configuration d'éclairement, la luminescence du soleil est environ 10⁶ à 10⁷ fois plus élevée que celle du limbe terrestre. Si aucune précaution particulière n'est prise, l'image du signal lumineux d'origine solaire défléchi par l'atmosphère au bord de la terre, disparaît, sur la matrice, dans la lumière parasite issue directement du soleil et réfléchie d'abord par la matrice elle-même puis, par les 2 dioptres de la fenêtre protectrice.

La matrice CCD TH 7864 de Thomson-CSF pourrait constituer un bon détecteur d'image utilisable dans l'application précise citée en dernier lieu, dans la mesure où il serait possible de s'affranchir de la fenêtre de protection qui referme le boîtier. Mais il n'est pas possible de supprimer cette fenêtre qui joue surtout un rôle de protection, un gaz inerte tel que de l'azote, par exemple, remplissant le volume confiné entre la fenêtre et la matrice. La matrice connue TH 7864 précitée comporte un boîtier au fond duquel est collée la puce de silicium qui constitue le détecteur proprement dit, ce boîtier étant muni de bords qui entourent la puce et présentent une surface située dans un plan selon une cote située à 0,84 mm au-delà de la surface sensible du détecteur. Contre cette surface est collée une fenêtre en verre optique de 0,9 mm d'épaisseur, tout à fait transparente en lumière visible. Dans ces conditions, les deux halos parasites créés autour de l'image du soleil sur la matrice par la réflexion de la lumière solaire directe sur la matrice puis sur les deux dioptres occupent des diamètres respectifs de l'ordre de 100 pixels et 200 pixels. Etant donné que le détecteur doit couvrir un champ supérieur au diamètre apparent de la terre, et que le diamètre du soleil est de l'ordre de 35 fois plus petit que celui de la terre vue depuis une orbite géostationnaire, l'image directe du soleil a un diamètre typique de 6 pixels et celle de la terre de 200 pixels. Comme par ailleurs la détection de la terre doit être assurée même lorsque le soleil est à proximité ou sur le limbe, l'image de la terre qu'on cherche à mesurer est en grande partie ou complètement masquée par chacun des deux halos parasites.

On connaît des dispositifs pour réduire les phénomènes d'éblouissement des détecteurs d'image. A cet effet, une première mesure consiste à munir l'objectif qui est placé devant le détecteur de lentilles photochromiques. Lorsque le détecteur est un tube à vide, une autre solution consiste à interposer, sur le trajet des électrons, une galette de microcanaux. Si la photocathode du tube reçoit un éclairement intense mais ponctuel, les propriétés de saturation locale de la galette de microcanaux limitent l'éblouissement tout en rendant possible l'observation du reste du paysage.

L'invention se propose de résoudre un problème technique plus limité et plus précis que celui indiqué au paragraphe précédent, consistant à s'affranchir de l'éblouissement dû, pour une source quasi-ponctuelle de rayonnement intense, aux seules réflexions parasites occasionnées par une fenêtre transparente placée juste devant la surface sensible d'un détecteur d'images.

Ce problème est résolu et les inconvénients de l'art antérieur sont atténués ou supprimés grâce au fait que le détecteur d'images défini en préambule est remarquable en ce que ladite fenêtre que comporte ce détecteur est constituée par un milieu transparent non diffusant et atténuateur dudit rayonnement photonique, que ledit dioptre interne est à une distance de ladite surface sensible qui est inférieure ou au plus égale à quelques fois la distance de résolution du détecteur, et que le dioptre externe est suffisamment éloigné de ladite surface sensible pour que la première réflexion du rayonnement issu de la source de rayonnement maximal ait, sur ladite surface sensible, un niveau inférieur au rayonnement direct issu de la source de rayonnement minimal à détecter.

La minimisation des deux halos parasites est ainsi obtenue par des mesures nettement différentes pour l'un et l'autre dioptre.

En ce qui concerne le dioptre interne, en rapprochant ce dernier par exemple de 1 mm à 20 µ, soit un rapport de l'ordre de 50, on réduit dans le même rapport le diamètre du halo proche. Pour le dioptre externe, au contraire, le but, en un sens inverse du précédent, est de rendre le halo le plus diffus possible en utilisant à la fois l'effet de dispersion sur la surface sensible de la matrice et un effet d'atténuation, par obscurcissement du milieu transparent, mettant à profit la double traversée de ce milieu.

Un mode de réalisation préféré d'un détecteur d'images selon l'invention est constitué par un senseur de limbe comportant une surface sensible au rayonnement visible organisée sous forme de barrettes ou de matrice du type CCD ou CID, ce détecteur étant incorporé à un boîtier muni de ladite fenêtre transparente placée devant la surface sensible. Ce mode de réalisation est en outre remarquable en ce qu'au moins le dioptre qui marque la séparation entre ladite fenêtre transparente et le milieu extérieur comporte des couches minces d'interférence anti-reflet.

Il est avantageux d'appliquer des couches anti-reflet sur les deux dioptres, interne et externe, de la fenêtre. On ramène ainsi le rapport de luminance de l'éclairement réfléchi par chaque dioptre de quelques pour cent à quelques pour mille, soit une atténuation de luminance des reflets parasites de l'ordre de 10.

La description qui suit, en regard des dessins annexés, le tout donné à titre d'exemple, fera bien comprendre comment l'invention peut être réalisée. Les dessins représentent :
- la figure 1, en coupe transversale à l'échelle 5, un détecteur d'images à matrice CCD selon l'art antérieur connu,
- la figure 2, en coupe transversale à l'échelle 5, un détecteur à matrice CCD selon l'invention,
- la figure 3, une partie très agrandie de la figure 2,
- la figure 4, en coupe avec arrachement, la partie avant de la matrice CCD et la fenêtre transparente, en trait interrompu selon l'art antérieur, et en trait plein selon l'invention.

Sur les figures, les mêmes références désignent les mêmes éléments avec les mêmes fonctions.

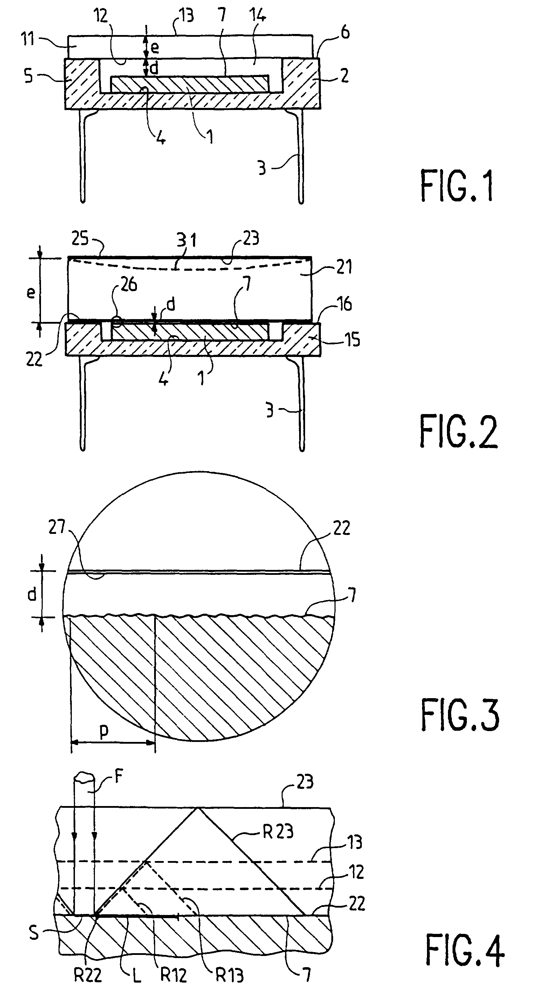

La figure 1 montre, à l'échelle 5 environ, une matrice CCD de Thomson-CSF, TH 7864.

La matrice photodétectrice 1, de 576 x 550 pixels est encapsulée dans un boîtier 2 en matériau électriquement isolant auquel sont solidarisées des broches de contact 3 de la matrice. La puce de silicium 1 est collée sur le fond 4 du boîtier 2, ce dernier étant muni de bords 5 qui entourent la matrice. La face antérieure 6 des bords 5 s'étend dans un plan situé à une distance d (d = 840 µ), devant la surface photosensible 7 de la matrice 1. Sur cette face 6 est collée une fenêtre transparente 11. La fenêtre 11 est en matériau optique entièrement transparent aux photons incidents, non diffusant et non chargé, d'une épaisseur e = 900 µ ; elle présente deux dioptres, un dioptre interne 12 et un dioptre externe 13. On supposera par la suite, pour fixer les idées, que le rayonnement incident est constitué par de la lumière visible, le matériau de la fenêtre étant du verre. Le volume libre enfermé entre la fenêtre 11 et le boîtier 2 est rempli d'azote à la pression atmosphérique. La surface 7 de la matrice présente un léger relief, à un niveau microscopique à cause des gravures successives effectuées avec des masques de photogravure différents nécessaires pour constituer la configuration de pixels désirée. Il en résulte qu'un faisceau incident de photons tombant sous incidence normale sur la surface 7 est réfléchi, à raison de 10 % environ, selon un tronc de cône de demi-angle au sommet de l'ordre de quelques dizaines de degrés (non représenté). Ce rayonnement parasite réfléchi est à son tour réfléchi, à raison de quelques centièmes par les dioptres 12 et 13 (typiquement 4 %). Il en résulte deux halos sur la surface photosensible 7 autour du centre de rayonnement incident, un halo réduit, de rayon r1 de l'ordre de 2d et un halo étendu, de rayon r2 de l'ordre de 2(d+e). On peut montrer que, avec les valeurs indiquées ci-dessus pour d et e, les rapports d'éclairement entre rayonnement incident et rayonnement parasite réfléchi sont, pour le premier halo, de l'ordre de quelques 10⁻⁵ et pour le deuxième, de l'ordre de 10⁻⁶. Le détecteur d'images de la figure 1 a été testé et convient bien pour des valeurs de contraste maximal de l'ordre de 10³ à 10⁴, ce qui est suffisant pour la plupart des applications.

Par contre, si l'on souhaite utiliser le détecteur tel quel comme senseur de terre en lumière visible, on est confronté à des contrastes lumineux supérieurs à 10⁷, résultant de la présence du disque solaire dans le champ à proximité du limbe de la terre, vers minuit, et des dimensions relatives entre les détails observés et la dimension des pixels (le limbe présentant une épaisseur 3 à 5 fois plus faible que la résolution du détecteur), c'est-à-dire des contrastes tels que les signaux utiles sont noyés dans chacun des deux halos parasites précités. Selon l'invention, pour s'affranchir des deux halos parasites en présence de contrastes lumineux supérieurs à 10⁷, on modifie le détecteur de la figure 1 comme représenté à la figure 2.

Sur la figure 2, certaines modifications d'ordre morphologiques, sont apparentes alors que d'autres ne sont pas visibles. La face antérieure 16 des bords 15 s'étend dans un plan qui est situé très légèrement en avant de la surface photosensible, à une distance d qui est de l'ordre de quelques microns, typiquement 10 µ, et en tout cas à une distance d inférieure à la distance de résolution qui est en pratique de l'ordre du côté p d'un pixel, typiquement compris entre 15 et 25 µ. Par ailleurs, l'épaisseur de la fenêtre transparente 21 a été portée à plusieurs mm de façon à rendre plus éloigné le dioptre externe 23.

Comme il s'avère difficile de diminuer suffisamment la luminance du halo réduit dû au dioptre interne 22, on fait en sorte que ce halo reste confiné très près de la source très brillante, en l'occurrence le.soleil. L'image du soleil sur la matrice consistant par exemple en une tache circulaire de rayon 3p, le rayon du halo réduit est ramené à environ 5p, soit une image du premier halo parasite du même ordre que celle du soleil lui-même, au lieu de recouvrir l'essentiel où même toute l'image du limbe de la terre que l'on cherche à détecter, de l'ordre d'une centaine de pixels disposés en arc de cercle. Pour ce qui est du halo parasite dû au dioptre externe 23, deux mesures au moins sont prises conjointement pour rendre sa luminance inférieure à celle du limbe terrestre, son plus grand éloignement, si nécessaire, comme déjà dit, par exemple égal à 4 mm, et un certain obscurcissement du milieu transparent constituant la fenêtre 21, dont la transmission est portée à une valeur typiquement comprise entre 0,05 et 0,3 et par exemple égale à 0,1. A cet effet, on peut utiliser par exemple, produit par la société allemande SCHOTT P.O.B. 2480, D-6500 MAINZ, un verre de densité neutre du type NG 4. Avec les valeurs numériques choisies ci-dessus, le contraste de la luminance du halo étendu ramenée à celle de l'image directe du soleil est abaissée en dessous de 10⁻⁸, ce qui constitue un bruit lumineux acceptable par rapport au signal utile du limbe terrestre. Si nécessaire on peut appliquer des couches minces d'interférences anti-reflet 25 sur le dioptre externe 23, ce qui ramène le taux de réflexion de quelques centièmes à un millième environ et permet de gagner ainsi un rapport 10 supplémentaire dans l'atténuation du halo parasite étendu. On peut aussi appliquer des couches anti-reflet sur le dioptre interne 22. Pour ce qui est du halo étendu, il est possible d'agir conjointement sur les deux paramètres d'épaisseur e, d'atténuation du verre, et sur l'application de couches anti-reflet, pour abaisser l'intensité lumineuse du halo étendu en dessous de tel ou tel seuil désiré.

La figure 3 représente, fortement agrandie, la partie 26 entourée d'un cercle de la figure 2. La surface sensible 7 est représentée avec un certain relief, qui provoque des réflexions obliques du faisceau lumineux, contrairement au dioptre interne 22 qui est plan. Le dioptre 22 peut être muni de multicouches anti-reflet 27. La distance p est de l'ordre de 20 µ et l'écartement d de l'ordre de 10 µ. Cette distance d peut être réduite presque à 0, les deux surfaces 7 et 22 étant alors au contact. On peut aussi solidariser les surfaces 7 et 22 au moyen de colle optique (peu diffusante).

Plusieurs solutions sont possibles pour la réalisation du détecteur de la figure 2. On peut utiliser une technologie semblable à celle utilisée pour le détecteur de la figure 1 mais avec des tolérances plus sévères pour l'écartement d. Le boîtier 22, au lieu d'être par exemple en céramique comme le boîtier 2 est avantageusement réalisé en métal, ce qui permet la mise en oeuvre de techniques d'usinage et d'assemblage bien connues en mécanique. Il faut alors veiller à isoler électriquement les traversées ménagées dans le boîtier pour le passage des contacts électriques 3. Pour cette réalisation, le collage facultatif de la matrice 1 à la fenêtre 21 peut s'effectuer de deux façon différentes. Soit on colle préalablement la matrice contre la fenêtre et ensuite ce sous-ensemble au boîtier sur des surfaces adaptées 4, respectivement 16, soit on colle d'abord la matrice au fond du boîtier, comme à la figure 1, puis la fenêtre simultanément à la surface 16 et à la surface 7 de la matrice avec des colles différentes, adaptées.

La figure 4 permet de comparer la marche des rayons parasites réfléchis, en trait interrompu selon l'art antérieur de la figure 1 et en trait plein selon l'invention (figures 2 et 3). La trace du soleil S sur la surface 7, très agrandie, est produite par le faisceau incident F. La trace L du limbe terrestre est environ 35 fois plus étendue que la trace S. Les réflexions parasites R12 et R13 recouvrent l'essentiel ou la totalité de la trace L, chacune ayant une intensité supérieure à L. Par contre, la trace de la réflexion parasite R22 est quasiment ponctuelle, alors que celle de la réflexion parasite R23 est nettement plus étendue que la trace L, ce qui la rend d'autant plus faible.

La luminance de l'atmosphère terrestre varie de 7,5 W/m x sr pour le soleil à midi à 0,1 W/m x sr pour le soleil à minuit (soleil en éclipse derrière la terre), soit un rapport de luminances égal à 75. L'atténuation apportée par la coloration dans la masse de la fenêtre transparente, selon l'invention peut être préjudiciable à la détection du limbe terrestre lorsque le soleil est occulté par la terre. Un mode de réalisation avantageux de l'invention consiste à utiliser un verre photochromique dont la transmission, à l'état sombre atteint une valeur comprise dans la fourchette précitée de 0,05 à 0,3, alors qu'à l'état clair la transmission peut dépasser 0,9. Un verre qui convient pour ce dernier mode de réalisation est par exemple un verre PGD ou PGE de la société Corning Europe, B.P. 3, 77210 AVON (France).

Un objectif est ordinairement positionné devant le détecteur. Cet objectif présente naturellement une courbure de champ, c'est-à-dire que l'image n'est pas plane, mais qu'elle se forme sur une sphère. Un moyen pour corriger ce défaut consiste à placer juste devant l'image une lentille divergente, cette dernière devant bien évidemment être prise en compte dans le calcul de la formule optique de l'objectif. Dans ce cas, la fenêtre peut réaliser cette fonction. Pour cela, il suffit de rendre concave le dioptre externe (épaisseur de la fenêtre la plus faible au centre, comme représenté par le trait interrompu 31 à la figure 2), de façon que la fenêtre se comporte comme une lentille divergente. On notera que cette solution est acceptable, dans un milieu atténuateur, à la seule condition que la concavité reste faible, devant l'épaisseur de la fenêtre, pour éviter une trop grande variation de la transmission dans le champ.

D'une façon générale, les détecteurs, matriciel ou en barrette, présentent une surface sensible entourée de structures plus ou moins complexes, telles que la zone mémoire, les registres de lecture, les circuits électroniques de commande et de lecture et autres. Ces structures présentent des parties pouvant être fortement réfléchissantes (masque aluminium des mémoires, dorures des circuits par exemple) et donc génératrices de lumière parasite. Comme la fenêtre transparente recouvre habituellement ces parties réfléchissantes non sensibles, il est avantageux, pour résoudre ce problème de lumière parasite additionnelle, de déposer ou de plaquer un masque absorbant (chrome "noir", noir d'or ou autre - non représenté) sur le dioptre interne de la fenêtre, ce masque délimitant la zone de surface utile du détecteur, pour arrêter les faisceaux tombant sur le reste de la surface du détecteur.

L'invention a été décrite ci-dessus pour une application très spécifique (senseur de terre) d'un détecteur d'image lui-même spécifique (matrice de CCD) ; elle peut cependant convenir pour d'autres types de détecteurs d'images et pour d'autres applications. Par exemple la matrice de détection peut être du type CID, c'est-à-dire adressable électroniquement. Au lieu d'une matrice il est aussi possible d'utiliser plusieurs barrettes de détection qui comportent chacune une fenêtre transparente selon l'invention (barrettes de CCD ou de photodiodes). Le détecteur peut aussi être un tube à vide à cathode photoémissive, un tube vidicon, par exemple. Il est aussi envisageable d'utiliser des matrices semiconductrices sensibles à certains rayonnements infrarouges. Le détecteur d'images peut fonctionner dans l'espace mais aussi au sol, sur terre notamment, en présence du soleil ou d'un projecteur lumineux puissant.

## Revendications

1. Détecteur d'images comportant une surface sensible à un rayonnement photonique, protégée du milieu extérieur par une fenêtre transparent (21) solidaire d'un boîtier (2), les faces interne et externe de ladite fenêtre délimitant un dioptre interne (22) et un dioptre externe (23), et placée devant ladite surface sensible (7), cette dernière présentant un état de surface propre à engendrer des réflexions de rayonnement selon des angles pouvant atteindre plusieurs dizaines de degrés par rapport à la direction de réflexion spéculaire sur ladite surface, caractérisé en ce que ladite fenêtre est constituée par un milieu transparent non diffusant et atténuateur dudit rayonnement photonique, que ledit dioptre interne est à une distance (d) de ladite surface sensible qui est inférieure ou au plus égale à quelques fois la distance de résolution du détecteur, et que le dioptre externe est suffisamment éloigné de ladite surface sensible pour que la première réflexion du rayonnement issu de la source de rayonnement maximal ait, sur ladite surface sensible, un niveau inférieur au rayonnement direct issu de la source de rayonnement minimal à détecter.

2. Détecteur d'images selon la revendication 1, constitué par un senseur de limbe comportant une surface sensible au rayonnement photonique, organisée sous forme de barrettes ou de matrice du type CCD, ou CID, ce détecteur étant incorporé à un boîtier muni de ladite fenêtre transparente placée devant la surface sensible, caractérisé en ce qu'au moins le dioptre qui marque la séparation entre ladite fenêtre transparente et le milieu extérieur comporte des couches minces d'interférence anti-reflet.

3. Détecteur d'images selon la revendication 2, comportant une surface sensible au rayonnement visible.

4. Détecteur d'images selon la revendications 2 ou 3 prises ensemble, caractérisé en ce que ladite fenêtre transparente est collée sur la surface sensible au moyen de colle optique.

5. Détecteur d'images selon l'une des revendications 1 à 4, caractérisé en ce que le coefficient de transmission du rayonnement photonique qui traverse ledit milieu transparent est compris entre 0,05 et 0,3.

6. Détecteur d'images selon l'une des revendications 1 à 5, caractérisé en ce que le dioptre externe de ladite fenêtre transparente se situe à une distance de ladite surface sensible qui est comprise entre 0,9 et 6 mm.

7. Détecteur d'images selon l'une des revendications 1 à 6, caractérisé en ce que ladite fenêtre optique est en verre optique photochrome.

8. Détecteur d'images selon l'une des revendications 1 à 7, caractérisé en ce que le dioptre externe de ladite fenêtre transparente est rendu concave de façon à transformer ladite fenêtre en une lentille divergente.

9. Senseur de terre pour satellite utilisant un détecteur d'images selon l'une des revendications précédentes 1 à 8.

## Patentansprüche

1. Bilddetektor mit einer für eine Photonenstrahlung empfindlichen Oberfläche, die vor der äußeren Umgebung durch ein vor der genannten empfindlichen Oberfläche (7) gelegenes transparentes Fenster (21) geschützt ist, das mit einem Gehäuse (2) verbunden ist, wobei die inneren und äußeren Flächen des genannten Fensters ein inneres Diopter (22) und ein äußeres Diopter (23) begrenzen und die empfindliche Oberfläche einen Oberflächenzustand aufweist, der geeignet ist, Strahlungsreflexionen in Winkeln zu erzeugen, die bezüglich der Spiegelreflexionsrichtung auf der genannten Fläche ein Vielfaches von zehn Grad erreichen können, dadurch gekennzeichnet, daß das in diesem Detektor enthaltene genannte Fenster durch eine transparente, die genannte Photonenstrahlung nicht-streuende und abschwächende Umgebung gebildet wird, das genannte innere Diopter sich in einem Abstand (d) zur genannten empfindlichen Oberfläche befindet, der kleiner oder gleich dem Mehrfachen des Auflösungsabstandes des Detektors ist, und das äußere Diopter von der genannten empfindlichen Oberfläche weit genug entfernt ist, damit die erste Reflexion der aus der maximalen Strahlungsquelle kommenden Strahlung auf der genannten empfindlichen Oberfläche ein niedrigeres Niveau aufweist als die direkt aus der zu detektierenden minimalen Strahlungsquelle kommende Strahlung.

2. Bilddetektor nach Anspruch 1, der aus einem Limbus-Sensor mit einer für Photonenstrahlung empfindlichen Oberfläche gebildet wird, die in Form von Stegen oder Matrizen des Typs CCD oder CID aufgebaut ist, wobei dieser Detektor in ein Gehäuse eingebaut ist, das mit dem vor der genannten empfindlichen Oberfläche plazierten genannten transparenten Fenster versehen ist, dadurch gekennzeichnet, daß wenigstens das Diopter, das die Trennung zwischen dem genannten transparenten Fenster und der äußeren Umgebung markiert, dünne antireflektierende Interferenzschichten umfaßt.

3. Bilddetektor nach Anspruch 2 mit einer für sichtbare Strahlung empfindlichen Oberfläche.

4. Bilddetektor nach Anspruch 2 oder 3 zusammengenommen, dadurch gekennzeichnet, daß das genannte transparente Fenster mittels optischem Klebstoff auf die empfindliche Oberfläche geklebt ist.

5. Bilddetektor nach einem der Ansprüche 1 bis 4, dadurch gekennzeichnet, daß der Transmissionskoeffizient der Photonenstrahlung, die die genannte transparente Umgebung passiert, zwischen 0,05 und 0,3 liegt.

6. Bilddetektor nach einem der Ansprüche 1 bis 5, dadurch gekennzeichnet, daß sich das äußere Diopter des genannten transparenten Fensters zu der genannten empfindlichen Oberfläche in einem Abstand befindet, der zwischen 0,9 und 6 mm liegt.

7. Bilddetektor nach einem der Ansprüche 1 bis 6, dadurch gekennzeichnet, daß das genannte optische Fenster ein photochromatisches optisches Glas ist.

8. Bilddetektor nach einem der Ansprüche 1 bis 7, dadurch gekennzeichnet, daß das äußere Diopter des genannten transparenten Fensters konkav ausgeführt wird, so daß das genannte Fenster in eine divergente Linse verwandelt wird.

9. Erdsensor für einen Satelliten, der einen Bilddetektor nach einem der vorstehenden Ansprüche 1 bis 8 verwendet.

## Claims

1. An image detector comprising a surface sensitive to photon radiation and protected from the external environment by a transparent window (21) which is integral with a housing (2), the internal and external surfaces of this window defining an internal diopter (22) and an external diopter (23) placed, in front of the said sensitive surface, the latter having a surface quality capable of generating radiation reflections over angles which can amount to several dozens of degrees relative to the direction of mirrored reflection on the said surface, characterized in that the said window which forms part of the detector is formed by a transparent, non-diffusing medium which attenuates the said photon radiation, in that the said internal diopter is at a distance (d) from the said sensitive surface which is smaller than or at most equal to several times the resolution distance of the detector, and in that the external diopter is sufficiently far removed from the said sensitive surface for the first reflection of the radiation coming from the source of maximum radiation to have a level, on the said sensitive surface, which is lower than that of the direct radiation coming from the source of minimum radiation which is to be detected.

2. An image detector as claimed in Claim 1, formed by a contour sensor comprising a surface sensitive to photon radiation and arranged in the form of strips or a matrix of the CCD type or CID type, which detector is incorporated in a housing provided with the said transparent window placed in front of the sensitive surface, characterized in that at least that diopter which marks the separation between the said transparent window and the external environment comprises thin anti-reflection interference layers.

3. An image detector as claimed in Claim 2, comprising a surface sensitive to visible radiation.

4. An image detector as claimed in Claims 2 and 3 taken together, characterized in that the said transparent window is glued to the sensitive surface by means of optical glue.

5. An image detector as claimed in any one of the Claims 1 to 4, characterized in that the transmission coefficient of the photon radiation traversing the said transparent medium lies between 0,05 and 0,3.

6. An image detector as claimed in any one of the Claims 1 to 5, characterized in that the external diopter of the said transparent window is situated at a distance of between 0,9 and 6 mm from the said sensitive surface.

7. An image detector as claimed in any one of the Claims 1 to 6, characterized in that the said optical window is made of photochromic optical glass.

8. An image detector as claimed in any one of the Claims 1 to 7, characterized in that the external diopter of the said transparent window is made concave so as to transform the said window into a divergent lens.

9. An earth sensor for a satellite using an image detector as claimed in any one of the preceding Claims 1 to 8.
